(19) Europäisches Patentamt
European Patent Office
Office européen des brevets

(11) EP 0 392 409 B1

(12) EUROPEAN PATENT SPECIFICATION

(45) Date of publication and mention of the grant of the patent:
**05.09.2001 Bulletin 2001/36**

(51) Int Cl.[7]: **G03F 7/09**, G03F 7/008, G03C 1/52, G03C 1/825

(21) Application number: **90106735.5**

(22) Date of filing: **09.04.1990**

(54) **Photoresist composition**

Photolackzusammensetzung

Composition de photoresist

(84) Designated Contracting States:
**BE DE FR GB IT NL**

(30) Priority: **10.04.1989 JP 9155189**

(43) Date of publication of application:
**17.10.1990 Bulletin 1990/42**

(73) Proprietor: **SUMITOMO CHEMICAL COMPANY LIMITED**
**Osaka-shi, Osaka 541-0041 (JP)**

(72) Inventors:
- **Takeyama, Naoki**
  **Osaka-fu (JP)**
- **Uetani, Yasunori**
  **Osaka-fu (JP)**
- **Nakanishi, Hirotoshi**
  **Mishima-gun, Osaka-fu (JP)**
- **Hanawa, Ryotaro**
  **Osaka-fu (JP)**

(74) Representative: **VOSSIUS & PARTNER**
**Postfach 86 07 67**
**81634 München (DE)**

(56) References cited:
**EP-A- 0 219 010**
**EP-A- 0 303 967**
**EP-A- 0 323 631**
**US-A- 4 135 007**

- **PATENT ABSTRACTS OF JAPAN vol. 10, no. 271 (P-497)(2327), 16 September 1986; & JP-A-61 093445 (FUJI) 12.05.1986**

EP 0 392 409 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

Printed by Jouve, 75001 PARIS (FR)

## Description

The present invention relates to a photoresist composition which can preferably be used to form fine patterns on a substrate having high reflectance in the production of semiconductors.

A photoresist which comprises a sensitizing compound having a quinone diazide group and a novolak resin, or which comprises a bisazide sensitizer and a cyclized rubber is used in the production of integrated circuits such as LSI.

In a process for producing the integrated circuits, fine patterns are formed on various substrates through photoresists. However, when conventional photoresists are used on substrates having high reflectance such as those made of aluminum, aluminum-silicon, polysilicon and the like, various problems arise. For example, a region which should not be exposed may be exposed because of reflection on a surface of the substrate and/or side walls of steps. This phenomenon is generally referred to as notching or halation.

To solve these problems and prevent deterioration of resolution, Japanese Patent Publication No. 37562/1976 proposes a photoresist composition which comprises, as a light absorber, a dye represented by the formula:

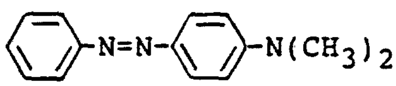

having characteristic absorptions in the ultraviolet range (Oil Yellow [C.I. 11020]). This photoresist composition can decrease light transmission through the photoresist layer and reduce the undesirable exposure of the substrate.

In the context of the present specification, a "photoresist" is intended to mean a composition which comprises a sensitizer and a resin, e.g. novolak, and a "photoresist composition" is intended to mean a composition which comprises a "photoresist" and a light absorber.

In general, if the light absorber is added to the photoresist, undesirable problems may arise. For example, photoresist drastically loses its sensitivity and productivity of the semiconductors is decreased.

The photoresist layer is usually formed by applying the photoresist composition containing a solvent on a wafer and prebaking the wafer with the applied photoresist composition to evaporate off the solvent. However, some light absorbers may precipitate during storage of the photoresist composition, or sublimate during prebaking so that a concentration of the light absorber in the photoresist layer formed on the wafer may be lowered, which leads to unsatisfactory results or variation in the quality of the produced semiconductors.

To solve these problems, phenylazobenzene derivatives are proposed in Japanese Patent Kokai (Laid-open) Publication Nos. 368358/1980 and 174941/1983. But, the use of such derivatives creates some problems. For example, the phenylazobenzene derivatives should be used in a large amount in order to obtain sufficient absorption at the desired wavelength, especially when the prebaking temperature is raised, or such derivatives have inferior anti-sublimation, a broad absorption range, low absorbing performance and undesirable absorption at certain wavelength. Japanese Patent Kokai Publication No. 93445/1986 discloses a photoresist composition comprising, as a light absorber, a certain styryl compound. Although the disclosed styryl compound can solve the problems associated with the prebaking, it greatly decreases the sensitivity of the photoresist.

Light absorbers encompassed by the general formula of the compound of the present invention are disclosed in documents US-A-4 135 007 and US-A-3 707 375, for use in a radiation curable weather resistant protective coating and in a colour photographic marerial having improved light fastness, respectively.

An object of the present invention is to provide a photoresist composition suitable for forming fine patterns having high resolution on a substrate having high reflectance without causing any halation or notching.

Another object of the present invention is to provide a photoresist composition which is stable against the prebaking of the substrate and suffers from less sensitivity deterioration caused by the addition of a light absorber.

Figs. 1A and 1B are a cross sectional view and a plan view of a pattern having steps for estimation, respectively,
Fig. 2 is a plane view of a substrate after a photoresist is coated, exposed and developed, in which the hatched part indicates the photoresist, and

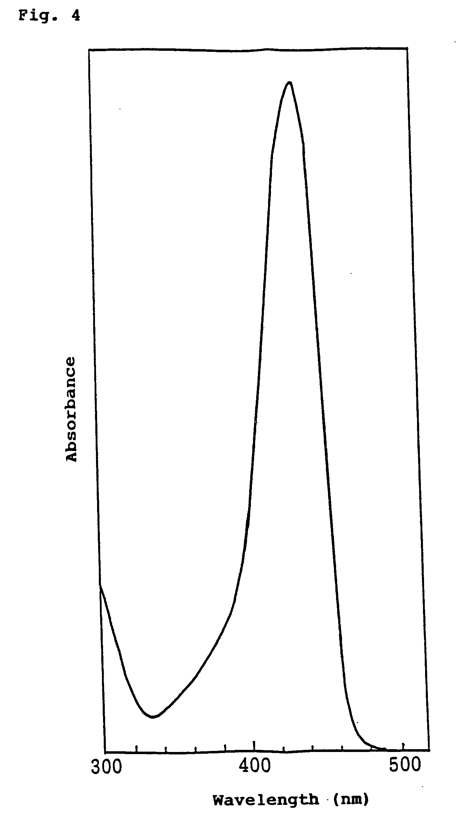

Figs. 3 and 4 show absorbance curves of the absorbers synthesized in Reference Example 1 and 3, respectively.

As a result of the extensive study, it has been found that a photoresist composition which comprises a specific compound as a light absorber accomplishes the above objects and solves the problems associated with the prior arts. The present invention has been completed based on this finding.

According to the present invention, there is provided a photoresist composition which comprises a compound of the general formula:

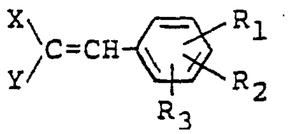

(I)

wherein $R_1$, $R_2$ and $R_3$ are the same or different and represent a hydrogen atom, a hydroxyl group, $-OCOR_4$, $-O-R_5$, $-OSi(R_6)_3$, a halogen atom, an optionally with at least one hydroxyl group substituted alkyl group, an optionally with at least one hydroxyl group substituted alkenyl group, an optionally with at least one hydroxyl group substituted phenyl group or an optionally with at least one hydroxyl group substituted aralkyl group; $R_4$, $R_5$ and $R_6$ represent an optionally with at least one hydroxyl group substituted lower alkyl group or an optionally with at least one hydroxyl group substituted phenyl group; X and Y are the same or different and represent -CN, $-COOR_7$,

$-CONR_8R_9$, 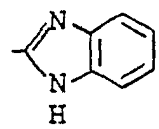 , or 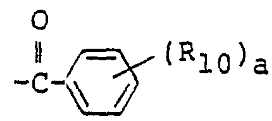 ,

$R_7$ represents an alkyl group; $R_8$ and $R_9$ are the same or different and represent a hydrogen atom, an optionally with at least one hydroxyl group substituted alkyl or phenyl group; $R_{10}$ represents a hydrogen atom, an optionally with at least one hydroxyl group substituted alkyl group or a hydroxyl group; and a is a number of 1 to 2 an alkali-soluble resin and a quinone diazide compound.

In the general formula (I), an alkyl group as $R_1$, $R_2$, $R_3$, $R_7$, $R_8$, $R_9$ or $R_{10}$ preferably has up to 4 carbon atoms. A lower alkyl group as $R_4$, $R_5$ or $R_6$ preferably has up to 6 carbon atoms, more preferably up to 4 carbon atoms.

A photoresist which comprises a novolak resin and a naphthoquinone diazide compound is preferably used. The novolak resin is obtained through the addition condensation reaction of a phenol compound with formaldehyde.

Also, a photoresist which comprises a cresol novolak resin and an ester of polyhydroxybenzophenone with naphthoquinone-1,2-diazide sulfonic acid is preferably used. The cresol novolak resin can be prepared by reactions of meta-cresol and/or para-cresol with formalin, or a reaction of meta-cresol, para-cresol and 3,5-xylenol with formalin. Examples of the polyhydroxybenzophenone are 2,3,4-trihydroxybenzophenone, 2,3,4,4'-tetrahydroxybenzophenone, 2,2',4,4'-tetrahydroxybenzophenone, 2,3,3',4-tetrahydroxybenzophenone, 2,2',3,4,5-pentahydroxybenzophenone, 2,3,3',4,5-pentahydroxybenzophenone, 2,3,3',4,4'-pentahydroxybenzophenone, 2,2',3,4,4'-pentahydroxybenzophenone, 2,2',3,3',4-pentahydroxybenzophenone, and the like.

Preferred examples of the compounds (I) which are suitable as the light absorber in the photoresist composition according to the present invention are as follows. These examples should not limit the scope of the present invention.

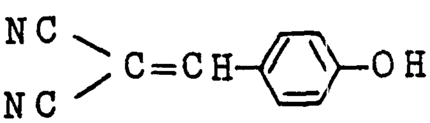

(1)

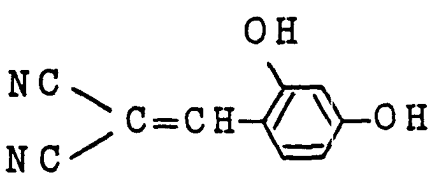

(2)

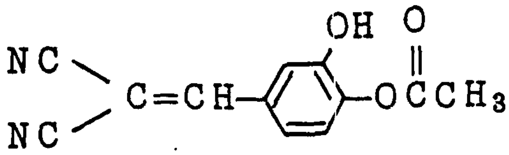

(3)

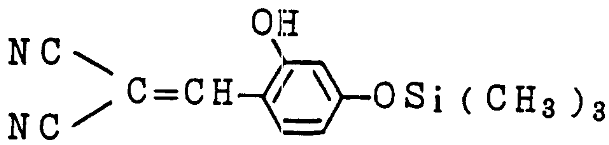

(4)

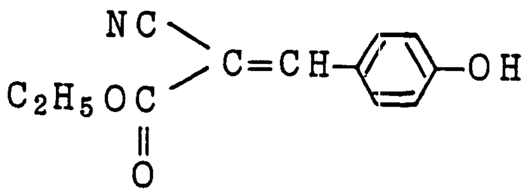

(5)

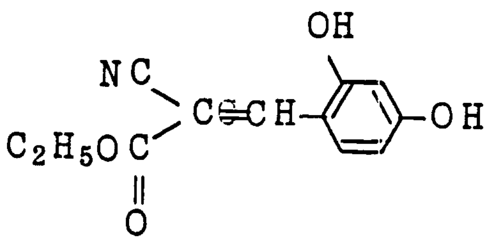

(6)

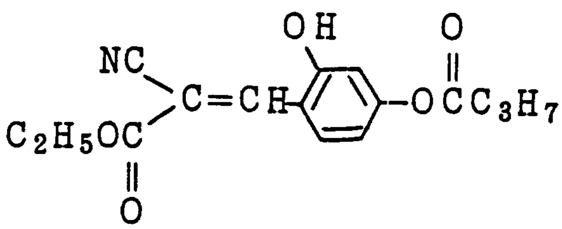

(7)

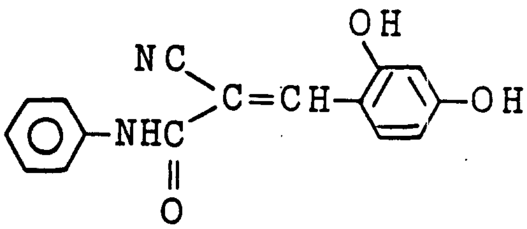

(8)

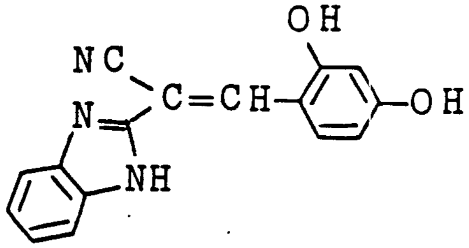

(9)

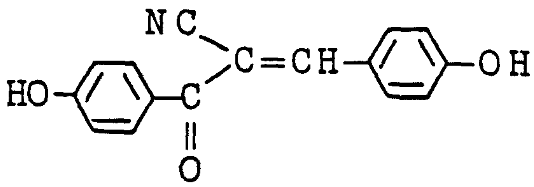

(10)

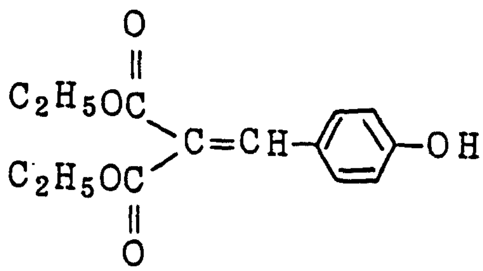

(11)

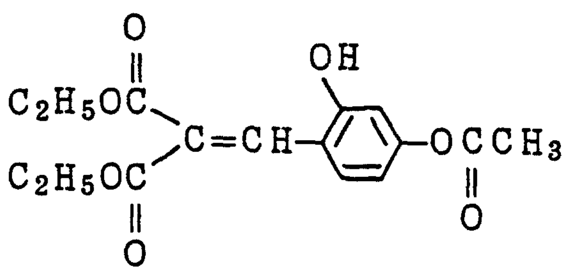

(12)

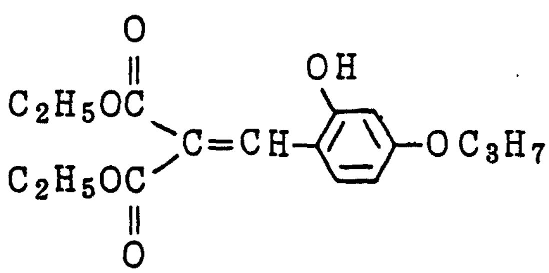

(13)

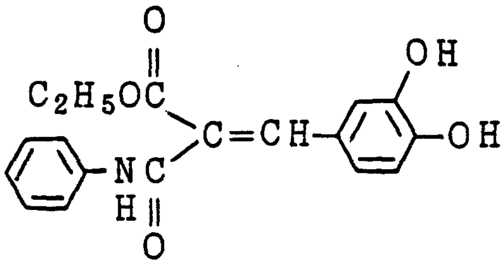

(14)

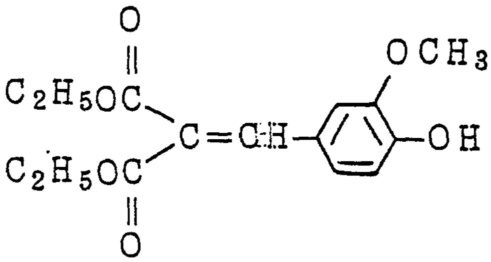

(15)

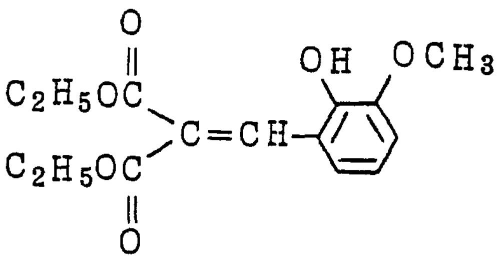

(16)

Among the compounds of the formula (I), those having absorption in a wavelength range not longer than 550 nm, particularly between 300 to 450 nm are preferably used in the photoresist composition.

The amount of compound (I) to be added to the photoresist composition is from 0.1 to 20 % by weight, preferably from 0.2 to 10 % by weight based on the weight of the solid component in the photoresist.

When the amount of compound (I) is in the above range, the photoresist composition sufficiently prevents the halation and has excellent profile and sensitivity.

The photoresist composition may optionally contain at least one other light absorber.

With the photoresist compositions according to the present invention, the problems associated with the prior arts can be solved, and patterns with high resolution can be formed on the substrate having high reflectance.

The invention also comprises the use of the above compound in a photoresist composition.

The present invention will be illustrated more in detail with the following examples, but should not be construed to be limited to these examples.

Reference Example 1

In a 300 ml four-necked flask with a stirring bar, a condenser and a thermometer, 13.8 g of 2,4-dihydroxybenzaldehyde, 25.2 g of diethyl malonate, and 100 g of ethanol were charged and stirred to obtain a homogeneous solution. 0.5 g of piperidine were added to the solution and stirred for 20 hours at 20-25°C. Ethanol was distilled off from a resulting solution by an evaporator to obtain 42.1 g of a tar-like yellow compound. To the resulting compound, 84 g of toluene were added and stirred for one hour at 70-75°C and cooled down to room temperature to precipitate the compound The precipitated compound was filtrated and dried to obtain 15.1 g of a crude cake. Then, in a 200 ml four-necked flask, 15.1 g of the crude cake and 90 g of toluene were charged and sintered for 2 hours at 70-75°C to obtain a dispersion. After cooling down to room temperature, the cake was filtrated and washed with 30 g of toluene. This was repeated twice to obtain 11.7 g of the compound of the following formula (I-a). The purity measured by HPLC was

98.8 %, and the structure of the compound was confirmed by NMR and mass spectrum.

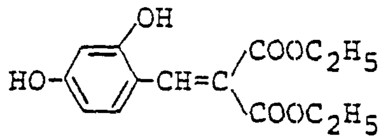

(I-a)

Absorbance of the compound (I-a) in methanol:

$\lambda_{max}$: 352 nm
ε: 2.58 x $10^4$ $M^{-1}.cm^{-1}$

Reference Example 2

In a 200 ml four-necked flask with a stirring bar, a condenser and a thermometer, 12.2 g of parahydroxybenzaldehyde, 9.9 g of malonitrile and 50 g of ethanol were charged and stirred to obtain a homogeneous solution. 0.5 g of piperidine were added to the solution, stirred for 16 hours at 20-25°C and filtrated to obtain a crystal. 60 g of toluene were added to the crystal and stirred for 2 hours, filterated and dried under vacuum to obtain a crude cake. 12.8 g of the crude cake was recrystallized from 32 g of ethyl acetate and dried under vacuum to obtain 4.8 g of the pale yellow compound of the following formula (I-b). The purity measured by HPLC was 98.2 % and the structure of the compound was confirmed by NMR and mass spectrum.

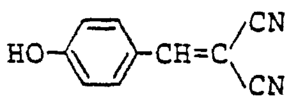

(I-b)

Absorbance of the compound (I-b) in methanol:

$\lambda_{max}$: 535 nm
ε: 2.91 x $10^4$ $M^{-1}.cm^{-1}$

Reference Example 3

In a 200 ml four-necked flask with a stirring bar, a condenser and a thermometer, 13.8 g of 2,4-dihydroxybenzaldehyde, 80 g of ethanol and 13.6 g of ethyl cyanoacetate were charged and stirred to obtain a homogeneous solution. 0.3 g of piperidine were added to the solution, stirred for 20 hours at 20-25°C and filtrated to obtain a crystal. 100 g of ethanol were added to the crystal and stirred for 2 hours and filtrated to obtain a cake. The cake was sinsed with 50 g of ethanol and dried under vacuum to obtain 18.4 g of the pale yellow compound of the formula (I-c). The purity measured by HPLC was 97.8 % and the structure of the compound was confirmed by NMR and mass spectrum.

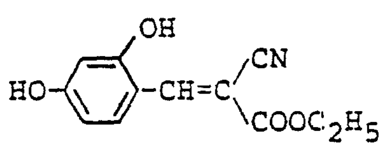

(I-c)

Absorbance of the compound (I-c) in methanol:

$\lambda_{max}$: 438 nm
ε: 3.46 x $10^4$ $M^{-1}.cm^{-1}$

Reference Example 4

In a 200 ml four-necked flask with a stirring bar, a condenser and a thermometer, 4.20 g of the compound obtained in Reference Example 1, 84 g of tetrahydrofuran and 1.59 g of triethylamine were charged and stirred to

obtain a homogeneous solution. 1.18 g of acetic chloride were diluted with 6.0 g of tetrahydrofuran (the molar ratio of the hydroxyl group to acetic chloride being 1:1) and dropwise added to the above homogeneous solution over 30 minutes at 20-25°C. After stirring for further 2 hours, the solution was poured into 500 ml of water and stirred for one hour. The mixture was filtrated, sinsed with 300 ml of water and dried under vacuum at 50-60°C to obtain 4.65 g of a partially acetylated compound of the compound (I-a).

Absorption of the partially acetylated compound in methanol:

$\lambda_{max}$: 343 nm
$\varepsilon$: 1.44 x $10^4$ $M^{-1}.cm^{-1}$

Reference Example 5

The same procedures of Reference Example 4 were repeated except that the compound (I-c) obtained in Reference Example 3 was used instead of the compound (I-a) to obtain a partially acetylated compound of the compound (I-c).

Absorbance of the partially acetylated compound in methanol:

$\lambda_{1\ max}$: 350 nm
$\varepsilon_1$: 1.01 x $10^4$ $M^{-1}.cm^{-1}$
$\lambda_{2\ max}$: 438 nm
$\varepsilon_2$: 7.70 x $10^4$ $M^{-1}.cm^{-1}$

Examples 1-4 and Comparative Example 2

Photoresist compositions were prepared by adding each dye compound shown in Table to a positive photoresist PF-6200 (manufactured by Sumitomo Chemical Company, Limited; a solid content of 31.0 % by weight), which comprises a novolak resin and at least one compound having o-quinone diazide groups. The amount of each dye compound added was determined to have the same absorbance as that in Comparative Example 2 (the amount of dye compound was 10 % by weight).

Each of the photoresist compositions was coated on a 4 inch square silicon wafer with an aluminum film on its surface by means of a spinner so as to form a resist film of 1.80 μm in thickness. Subsequently, the silicon wafer was baked for one minute on a hot plate kept at 100°C, and exposed to light (i-line of 365 nm) through a test reticule while varying the exposure value stepwise by means of a reduced projection exposing apparatus. Thereafter, the silicon wafer was developed by a static paddle method for 60 seconds at 23°C in a developing solution SOPD (manufactured by Sumitomo Chemical Company, Limited) by means of an automatic developing machine. The results are shown in Table.

The anti-halation effect was estimated as follows:

The method of estimation of a preventive effect of halation

1. Making a substrate having steps for estimation

On a silicon substrate having a $SiO_2$ film of 1 μm in thickness, a pattern having steps a shape of which is shown in Figs. 1A and 1B was formed by photolithography, etching and aluminum spattering. Typical pattern sizes are a = 4 μm, b = 2 μm, c = 1 μm and d = 1 μm.

2. Estimation of anti-halation effect

On the above substrate having high reflectance and the steps, a resist film of 2 μm in thickness was coated by the spin coat method.

The resist film was exposed to light and developed to make a resist line with a line width of 1.2 μm across the center concave part of the above pattern (see Fig. 2).

A decreasing ratio (R) of the resist line width in the concave center of the step (y) to a line width in the part having no step (x) was calculated according to the following equation:

$$R = \frac{x - y}{x}$$

In estimating the preventive effect, the exposure dose was settled 1.3 times of the exposure dose at which the remaining film thickness becomes zero.

The anti-halation effect is evaluated according to the following criteria:

Very good: The decreasing ratio of the line width is within 10 %.
Good: The decreasing rate of the line width is from 11 to 20 %.
No good: The decreasing rate of the line width is more than 20 %.

Comparative Example 1

The same procedures as in Comparative Example 2 were repeated except that no absorber was used.

The anti-halation effect was estimated in the same method as in Comparative Example 2 and the results are summarized in Table.

Table

| Example No. | Absorber compound | Relative sensi-tivity | Absor-bance ratio | Anti-halation effect |
|---|---|---|---|---|
| 1 | (I-a) | 1.2 | 1 | Very good |
| 2 | (I-b) | 1.2 | 1 | Very good |
| 3 | Partially acetylated compound of (I-a) | 1.3 | 1 | Very good |
| 4 | Partially acetylated compound of (I-c) | 1.3 | 1 | Very good |
| Comp. 1 | None | 1 | 0.3 | Not good |
| Comp. 2 | Note *1) | 2.3 | 1 | Good |

Note: *1) 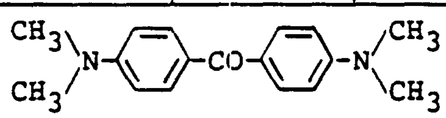

As understood from the results in Table, patterns with high sensitivity were formed in Examples of the present invention.

The pattern could be resolved sharply. No notching caused by reflected light on the side surfaces of patterns was found. The above results indicate that the photoresist composition of the present invention imparts excellent anti-halation effect.

In comparison with the photoresists in Examples, the photoresists in Comparative Examples exhibited insufficient sensitivity and anti-halation effect.

## Claims

**1.** A photoresist composition which comprises a compound of the general formula:

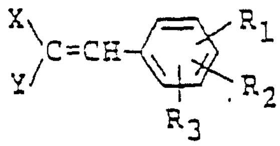

(I')

wherein $R_1$, $R_2$ and $R_3$ are the same or different and represent a hydrogen atom, a hydroxyl group, $-OCOR_4$, $-O-R_5$, $-OSi(R_6)_3$, a halogen atom, an optionally with at least one hydroxyl group substituted alkyl group, an optionally with at least one hydroxyl group substituted alkenyl group, an optionally with at least one hydroxyl group substituted phenyl group or an optionally with at least one hydroxyl group substituted aralkyl group; $R_4$, $R_5$ and $R_6$ represent an optionally with at least one hydroxyl group substituted lower alkyl group or an optionally with at least one hydroxyl group substituted phenyl group; X and Y are the same or different and represent -CN, -COOR7,

$-CONR_8R_9$, 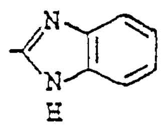 , or 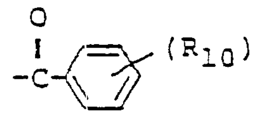 ,

$R_7$ represents an alkyl group; $R_8$ and $R_9$ are the same or different and represent a hydrogen atom, an optionally with at least one hydroxyl group substituted alkyl or phenyl group; $R_{10}$ represents a hydrogen atom, an optionally with at least one hydroxyl group substituted alkyl group or a hydroxyl group; and a is a number of 1 to 2; an alkali-soluble resin and a quinone diazide compound.

**2.** The photoresist composition according to claim 1, wherein the alkali-soluble resin is a novolak resin and wherein the quinone diazide compound is a naphthoquinone diazide compound.

**3.** The photoresist composition according to claim 2, wherein the novolak resin is a cresol novolak resin and the naphthoquinone compound is an ester of polyhydroxybenzophenone with naphthoquinone-1,2-diazide sulfonic acid.

**4.** Use of a compound of the general formula:

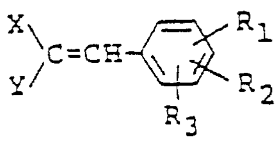

(I')

wherein $R_1$, $R_2$ and $R_3$ are the same or different and represent a hydrogen atom, a hydroxyl group, $-OCOR_4$, $-O-R_5$, $-OSi(R_6)_3$, a halogen atom, an optionally with at least one hydroxyl group substituted alkyl group, an optionally with at least one hydroxyl group substituted alkenyl group, an optionally with at least one hydroxyl group substituted phenyl group or an optionally with at least one hydroxyl group substituted aralkyl group; $R_4$, $R_5$ and $R_6$ represent an optionally with at least one hydroxyl group substituted lower alkyl group or an optionally with at least one hydroxyl group substituted phenyl group; X and Y are the same or different and represent -CN, $-COOR_7$,

$-CONR_8R_9$, 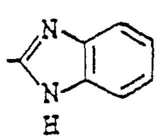 , or 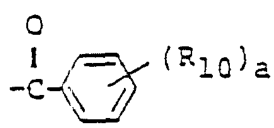 ,

$R_7$ represents an alkyl group; $R_8$ and $R_9$ are the same or different and represent a hydrogen atom, an optionally with at least one hydroxyl group substituted alkyl or phenyl group; $R_{10}$ represents a hydrogen atom, an optionally with at least one hydroxyl group substituted alkyl group or a hydroxyl group; and a is a number of 1 to 2;
in a photoresist composition,

5. Use according to claim 4, wherein the photoresist composition comprises a novolak resin and a naphthoquinone diazide compound.

6. Use according to claim 5, wherein the photoresist composition comprises a cresol novolak resin and an ester of polyhydroxybenzophenone with naphthoquinone-1,2-diazide sulfonic acid.

**Patentansprüche**

1. Photoresistzusammensetzung, umfassend eine Verbindung der allgemeinen Formel

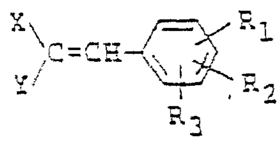

(I')

wobei $R_1$, $R_2$ und $R_3$ gleich oder verschieden sind und ein Wasserstoffatom, eine Hydroxylgruppe, $-OCOR_4$, $-O-R_5$, $-OSi(R_6)_3$, ein Halogenatom, einen gegebenenfalls mit mindestens einer Hydroxylgruppe substituierten Alkylrest, einen gegebenenfalls mit mindestens einer Hydroxylgruppe substituierten Alkenylrest, eine gegebenenfalls mit mindestens einer Hydroxylgruppe substituierte Phenylgruppe oder einen gegebenenfalls mit mindestens einer Hydroxylgruppe substituierten Aralkylrest darstellen; $R_4$, $R_5$ und $R_6$ einen gegebenenfalls mit mindestens einer Hydroxylgruppe substituierten Niederalkylrest, oder eine gegebenenfalls mit mindestens einer Hydroxylgruppe substituierte Phenylgruppe darstellen; X und Y gleich oder verschieden sind und -CN, $-COOR_7$, $-CONR_8R_9$,

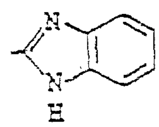 , 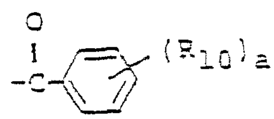 ,

darstellen;
$R_7$ einen Alkylrest darstellt; $R_8$ und $R_9$ gleich oder verschieden sind und ein Wasserstoff atom, einen gegebenenfalls mit mindestens einer Hydroxylgruppe substituierten Alkylrest oder eine Phenylgruppe darstellen; $R_{10}$ ein Wasserstoffatom, einen gegebenenfalls mit mindestens einer Hydroxylgruppe substituierten Alkylrest oder eine Hydroxylgruppe darstellt; und a 1 oder 2 ist; ein alkalilösliches Harz und eine Quinondiazidverbindung.

2. Photoresistzusammensetzung nach Anspruch 1, wobei das alkalilösliche Harz ein Novolakharz und die Quinondiazidverbindung eine Naphthoquinondiazidverbindung ist.

3. Photoresistzusammensetzung nach Anspruch 2, wobei das Novolakharz ein Kresolnovolakharz und die Naphthoquinonverbindung ein Ester des Polyhydroxybenzophenons mit einer Naphthoquinon-1,2-diazid-Sulfonsäure ist.

4. Verwendung einer Verbindung der allgemeinen Formel

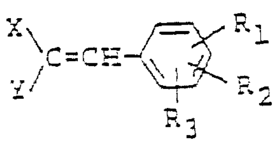

(I')

in einer Photoresistzusammensetzung,
wobei $R_1$, $R_2$ und $R_3$ gleich oder verschieden sind und ein Wasserstoffatom, eine Hydroxylgruppe, $-OCOR_4$, $-O-R_5$, $-OSi(R_6)_3$, ein Halogenatom, einen gegebenenfalls mit mindestens einer Hydroxylgruppe substituierten Alkylrest, einen gegebenenfalls mit mindestens einer Hydroxylgruppe substituierten Alkenylrest, eine gegebenenfalls mit mindestens einer Hydroxylgruppe substituierte Phenylgruppe oder einen gegebenenfalls mit mindestens einer Hydroxylgruppe substituierten Aralkylrest darstellen; $R_4$, $R_5$ und $R_6$ einen gegebenenfalls mit mindestens einer

Hydroxylgruppe substituierten Niederalkylrest, oder eine gegebenenfalls mit mindestens einer Hydroxylgruppe substituierte Phenylgruppe darstellen; X und Y gleich oder verschieden sind und -CN, $-COOR_7$, $-CONR_8R_9$,

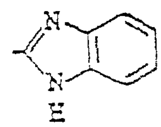 , 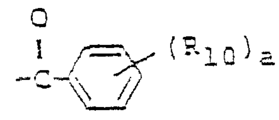 ,

darstellen;
$R_7$ einen Alkylrest darstellt; $R_8$ und $R_9$ gleich oder verschieden sind und ein Wasserstoffatom, einen gegebenenfalls mit mindestens einer Hydroxylgruppe substituierten Alkylrest oder eine Phenylgruppe darstellen; $R_{10}$ ein Wasserstoffatom, einen gegebenenfalls mit mindestens einer Hydroxylgruppe substituierten Alkylrest oder eine Hydroxylgruppe darstellt; und a 1 oder 2 ist.

**5.** Verwendung nach Anspruch 4, wobei die Photoresistzusammensetzung ein Novolakharz und eine Naphthoquinondiazidverbindung umfaßt.

**6.** Verwendung nach Anspruch 5, wobei die Photoresistzusammensetzung ein Kresolnovolakharz und einen Ester des Polyhydroxybenzophenons mit Naphthoquinon-1,2-diazid-Sulfonsäure umfaßt.

**Revendications**

**1.** Composition de photoréserve qui comprend un composé de formule générale :

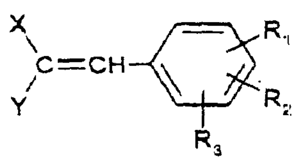 (I)

dans laquelle $R_1$, $R_2$ et $R_3$ sont identiques ou différents et représentent un atome d'hydrogène, un groupe hydroxyle, $-OCOR_4$, $-O-R_5$, $-OSi\ (R_6)_3$, un atome d'halogène, un groupe alkyle éventuellement substitué par au moins un groupe hydroxyle, un groupe alcényle éventuellement substitué par au moins un groupe hydroxyle, un groupe phényle éventuellement substitué par au moins un groupe hydroxyle ou un groupe aralkyle éventuellement substitué par au moins un groupe hydroxyle ; $R_4$, $R_5$ et $R_6$ représente un groupe alkyle inférieur éventuellement substitué par au moins un groupe hydroxyle ou un groupe phényle éventuellement substitué par au moins un groupe hydroxyle ; X et Y sont identiques ou différents et représentent -CN, $-COOR_7$, $-CONR_8R_9$,

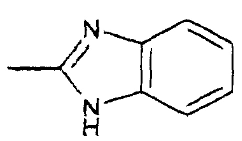 ou 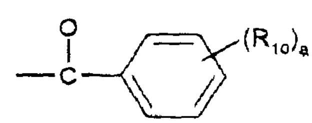

$R_7$ représente un groupe alkyle ; $R_8$ et $R_9$ sont identiques ou différents et représentent un atome d'hydrogène, un groupe alkyle ou phényle éventuellement substitué par au moins un groupe hydroxyle ; $R_{10}$ représente un atome d'hydrogène, un groupe alkyle éventuellement substitué par au moins un groupe hydroxyle ou un groupe hydroxyle ; et a est un nombre de 1 à 2 ; une résine soluble dans les alcalis, et un composé quinone-diazoture.

**2.** Composition de photoréserve selon la revendication 1, dans laquelle la résine soluble dans les alcalis est une résine novolaque et dans laquelle le composé quinone-diazoture est un composé naphtoquinone-diazoture.

**3.** Composition de photoréserve selon la revendication 2, dans laquelle la résine novolaque est une résine novolaque de crésol et le composé naphtoquinone est un ester de polyhydroxybenzophénone avec de l'acide naphtoquinone-1,2-diazidosulfonique.

**4.** Utilisation d'un composé de formule générale :

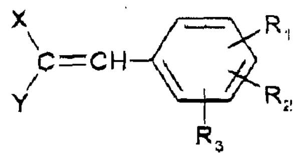

(I)

dans laquelle $R_1$, $R_2$ et $R_3$ sont identiques ou différents et représentent un atome d'hydrogène, un groupe hydroxyle, $-OCOR_4$, $-O-R_5$, $-OSi(R_6)_3$, un atome d'halogène, un groupe alkyle éventuellement substitué par au moins un groupe hydroxyle, un groupe alcényle éventuellement substitué par au moins un groupe hydroxyle, un groupe phényle éventuellement substitué par au moins un groupe hydroxyle ou un groupe aralkyle éventuellement substitué par au moins un groupe hydroxyle ; $R_4$, $R_5$ et $R_6$ représentent un groupe alkyle inférieur éventuellement substitué par au moins un groupe hydroxyle ou un groupe phényle éventuellement substitué par au moins un groupe hydroxyle ; X et Y sont: identiques ou différents et représentent -CN, $-COOR_7$, $-CONR_8R_9$,

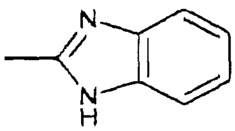

ou

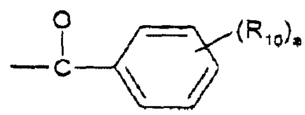

$R_7$ représente un groupe alkyle ; $R_8$ et $R_9$ sont identiques ou différents et représentent un atome d'hydrogène, un groupe alkyle ou phényle éventuellement substitué par au moins un groupe hydroxyle ; $R_{10}$ représente un atome d'hydrogène, un groupe alkyle éventuellement substitué par au moins un groupe hydroxyle ou un groupe hydroxyle ;
et a est un nombre de 1 à 2 ;
dans une composition de photoréserve.

**5.** Utilisation selon la revendication 4, dans laquelle la composition de photoréserve comprend une résine novolaque et un composé naphtoquinone-diazoture.

**6.** Utilisation selon la revendication 5, dans laquelle la composition de photoréserve comprend une résine novolaque de crésol et un ester de polyhydroxybenzophénone avec de l'acide naphtoquinone-1,2-diazidosulfonique.

Fig. 1A

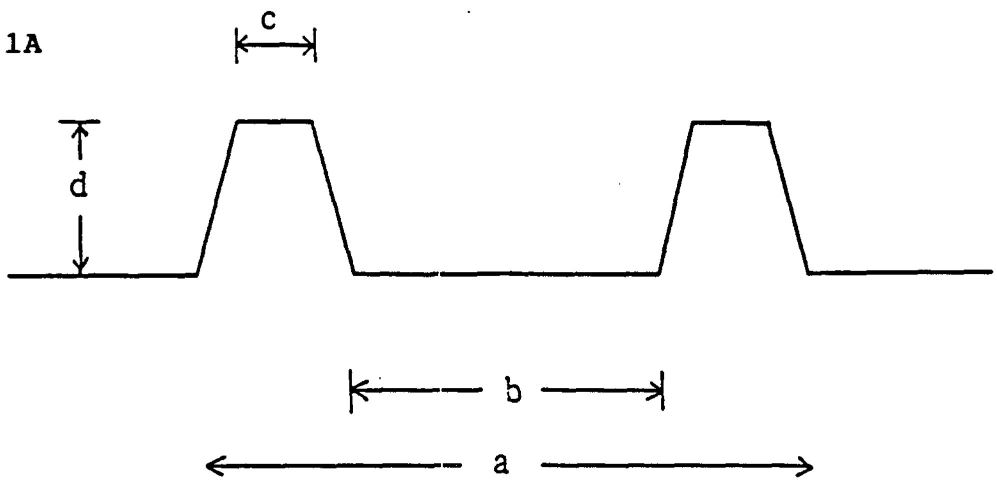


Fig. 1B

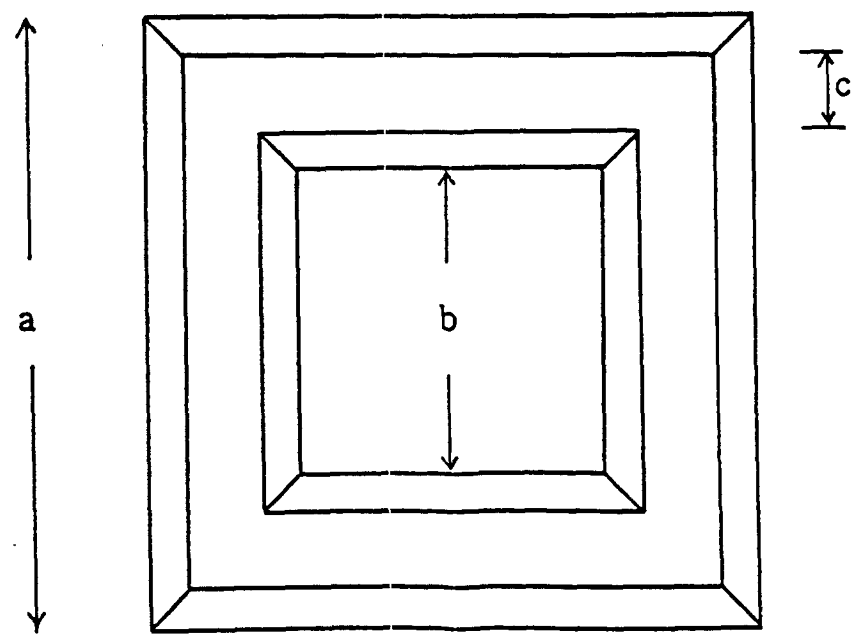

Fig. 2

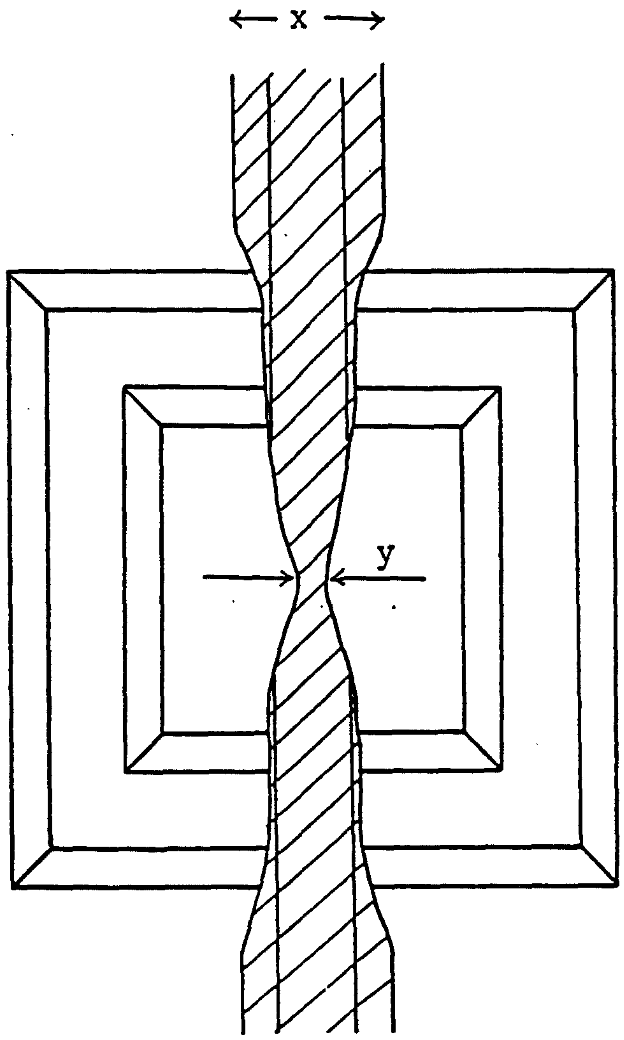

Fig. 3

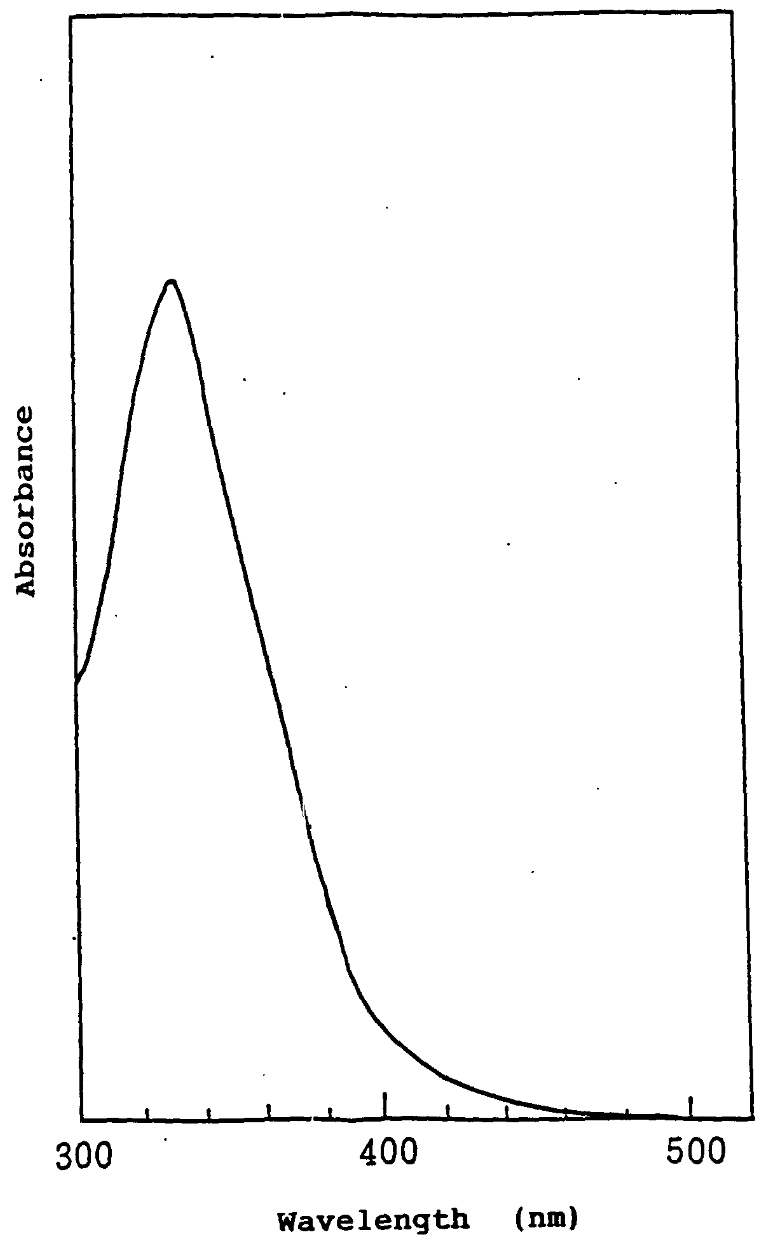

Fig. 4